# EUROPEAN PATENT SPECIFICATION

(11) **EP 2 321 656 B1**
(45) Date of publication and mention of the grant of the patent: **15.05.2013**
(21) Application number: 09807498.2
(22) Date of filing: 25.08.2009
(51) Int. Cl.: G01R 15/18, G01R 19/20

(54) **METHOD AND APPARATUS FOR MEASURING DIRECT CURRENTS FLOWING IN AN ELECTRIC LINE**
VERFAHREN UND VORRICHTUNG ZUR MESSUNG DES GLEICHSTROMFLUSSES IN EINER ELEKTRISCHEN LEITUNG
PROCÉDÉ ET APPAREIL DE MESURE DE COURANTS CONTINUS DANS UNE LIGNE ÉLECTRIQUE

(30) Priority: 28.08.2008 IT MI20081550
(43) Date of publication of application: 18.05.2011
(73) Proprietor: Sirti S.p.A., 20127 Milano (IT)
(72) Inventor: MORELLI, Maurizio, 16138 Genova (IT); TRENTINI, Daniele, 16149 Genova (IT)
(74) Representative: Di Gennaro, Sergio
(86) International application number: PCT/IB2009/006646
(87) International publication number: WO 2010/035089

(56) References cited:
- US-A- 3 812 428
- ZIEGLER S ET AL: "Transformer based DC current sensor for digitally controlled power supplies" UNIVERSITIES POWER ENGINEERING CONFERENCE, 2007. AUPEC 2007. AUSTRALASIAN, IEEE, PISCATAWAY, NJ, USA, 9 December 2007 (2007-12-09), pages 1-6, XP031275414 ISBN: 978-0-646-49488-3
- HARADA K ET AL: "CURRENT SENSORS WITH A SMALL SATURABLE CORE AND MOSFETS" IEEE TRANSACTIONS ON MAGNETICS, IEEE SERVICE CENTER, NEW YORK, NY, US, vol. 24, no. 6, 1 November 1988 (1988-11-01), pages 2910-2912, XP000029718 ISSN: 0018-9464

## Description

The present invention refers to a method and apparatus measuring direct currents.

In the railway signalling sector there is a strong need for measuring direct currents having an intensity variable from 0 to about a hundred mA, for example in lines where active components cannot be enabled for safety reasons.

The present invention tackles the problem regarding how to measure a direct current with a sign in an environment of the abovementioned type without requiring using active components.

The proposed solution is based on the magnetic saturation characteristics of saturated iron transformers, having a low hysteresis cycle, an asymmetrically shaped hysteresis loop and a very high magnetic permeability, obtaining a method capable of reading the direct currents introduced into the primary of the transformer itself, as outlined hereinafter.

The magnetic core of a transformer is saturated depending on the amplitude of the voltage supplying its winding, and thus on the amplitude of the inducer flow, depending on whether one is operating on the linearity or whether saturation is attained, passing from a sinusoidal development to a more deformed development of the magnetizing current as the saturation increases. Supplying a transformer winding with a sinusoidal voltage consequently leads to obtaining a sinusoidal magnetic flow.

Direct current, object of the measurement, which passes through the primary of the transformer polarises it and thus in order to obtain the maximum reading of the set sinusoidal value on the secondary of the transformer itself it is necessary to set a direct current of the same value as that to be measured set on the primary lower than the turns ratio between the primary and the secondary (with an ideally unitary proportionality constant obtained in the step of calibrating the apparatus) and with direction (or sign) such to rebalance or counter-polarise the transformer magnetic core.

Document US3812428A proposes a method and a system for measuring direct currents using a magnetic core. For safety reasons, in the railway signalling applications it is extremely important to quickly detect the value and sign variations of the direct current in the lines and such system may not detect it within the required times.

The present invention overcomes the abovementioned drawback by providing a system wherein the direct current variation at the primary of the transformer immediately turns into the reading of the sinusoidal value, at the secondary of the transformer, lower than the maximum value allowing immediate detection of a "direct current value variation" event.

An aspect of the present invention regards an apparatus for measuring direct currents flowing in an electric line according to the characteristics of claim 1.

A further aspect of the present invention regards a method for measuring direct currents flowing in an electric line according to the characteristics of claim 5.

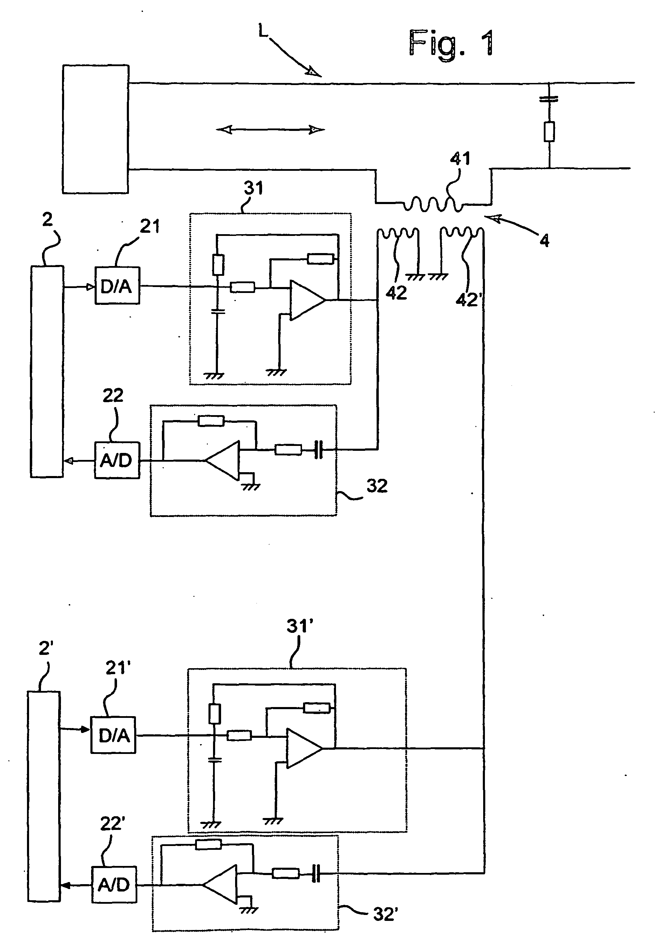

Characteristics and advantages of the method and apparatus according to the present invention shall be more clear and apparent from the following exemplifying and non-limiting description of an embodiment provided with reference to the attached figure 1 which represents a block diagram of the apparatus according to the present invention.

With reference to the abovementioned figure the apparatus according to the present invention is applied to a line L whose direct current is intended to be measured.

The apparatus comprises at least one measurement block including at least one processing unit 2, which in an application particularly in the railway industry - may correspond to the abovementioned Field controller unit CE (i.e. the device for controlling Field Interfaces). The measuring block comprises a branch for generating a reference current made up of a sinusoidal current (for example at a 30 KHZ frequency) having a predetermined efficiency value, such to move the magnetic core of the transformer to the saturation threshold, and by an adjustable direct current - in terms of sign and value - as well as a branch for detecting the sinusoidal component of such reference current.

Furthermore, the apparatus comprises a transformer 4 with a saturated iron core having a primary winding 41 arranged on the line whose current CC is intended to be measured and at least one secondary winding 42 applied on which is the reference current signal generated through such processing unit.

Such unit controls and manages at least one digital/analogue converter 21 and at least one analogue/digital converter 22. The apparatus also comprises an amplification and filtering stage 31 and at least one band-pass filter 32.

In particular, the unit for processing through the digital/analogue converter 21 and the amplification stage 31 introduces the reference current into the secondary of the transformer 42.

The processing unit reads the sinusoidal voltage at the secondary of the transformer through the analogue/digital converter 22 and the band-pass filter 32.

The processing unit compares the samples received from the A/D converter with those sent by the D/A converter and adjusts the value of the direct current overlapped with the alternating one until the samples received correspond to those of maximum value. In other words, the adjustment unit adjusts the value and sign of the direct current overlapped with the alternating one until the sinusoidal voltage efficiency value measured on the secondary of the transformer acquires the maximum value. Once the maximum value of the data received is detected, the direct current to be measured flowing in the primary of the transformer subject of the measurement is proportional (with an ideally unitary proportionality constant obtained in the step of calibrating the apparatus) to the reference adjusted value sent in the secondary processing unit which is thus known.

Present in the embodiment illustrated in the figure are two identical measurement blocks which operate parallel to each other, thus the signal is sent to two identical secondaries 42 and 42' of the transformer and processed twice. The two direct currents measured through the method according to the present invention are compared to each other for further verification.

In practice, the method comprises the following steps. Introducing the direct current to be measured into the primary winding of a transformer having a saturates iron core.

Sending to a secondary winding of such transformer a reference current made up of a predetermined frequency sinusoidal component and efficiency value such to move the magnetic core of the transformer to the threshold of saturation and a direct current component adjustable in terms of value and sign.

Measuring the value of the reference direct current on the secondary of the transformer and the value of the sinusoidal voltage.

Adjusting the direct current component of the reference current on the secondary of the transformer in terms of value and sign until the sinusoidal value of the voltage measured on the secondary of the transformer corresponds to the maximum value, thus removing the saturated iron magnetic core of the transformer from the saturation. The value of the reference direct current on the secondary of the transformer shall thus be proportional (with an ideally unitary proportionality constant obtained during the step of calibrating the apparatus) to the value of the direct current circulating on the primary of the transformer, current subject of the measurement.

## Claims

1. Apparatus for measuring direct currents flowing in a line (L),
comprising
• a transformer (4) having a saturated iron core wherein flowing in the primary winding (41) is the direct current to be measured,
**characterised in that** it comprises
• a measuring block comprising
o a branch for generating a reference current, made up of a sinusoidal current having a predetermined and by an adjustable direct current, to be sent to a secondary winding (42, 42') of such transformer,
o a branch for detecting the sinusoidal component of said reference current of the secondary winding of said transformer,
o a processing unit (2,2') adapted to control said branches, to adjust the value of said direct current component of the reference current until the root-mean-square value of the sinusoidal component reach a maximum value,
o said processing unit calculates the value of the direct current to be measured as the value of the reference direct current component sent to the secondary winding of said transformer multiplied by a proportionality constant obtained during adjusting the value of said direct current.

2. Apparatus according to claim 1, wherein said generation branch comprises a digital/analogue converter (21,21') controlled by said processing unit and at least one amplification block (31,31').

3. Apparatus according to claim 1, wherein said detection branch comprises an analogue/digital converter (22,22') controlled by said processing unit and at least one passband filter (32,32').

4. Apparatus according to claim 1, comprising two measuring blocks each associated to a respective secondary winding (42,42') of said transformer.

5. Method for measuring a direct current flowing in a line (L) **characterised in that** it comprises the following steps:
a) inserting the direct current to be measured into the primary winding of a transformer having a saturated iron magnetic core,
b) sending into a secondary winding of said transformer a reference current made up of an adjustable direct current component and a sinusoidal component with predetermined frequency and root-mean-square value, in such a manner to remove from the saturation said saturated iron magnetic core,
c) detecting said sinusoidal current component and comparing it with the sinusoidal portion of the sent reference current,
d) adjusting such direct current component of the reference current up to a value in which the root-mean-square value of the sinusoidal component takes up the maximum value,
e) calculating the value of the direct current to be measured at step a) as the value of the reference direct current component sent to the secondary winding of said transformer obtained during the step d) of adjusting, multiplied for a proportionality constant

6. Method according to claim 5, further comprising the steps of
f) repeating the measurement carried out in steps a)- e) by means of two apparatus according to claim 1,
g) comparing the results of the two measurements.

## Patentansprüche

1. Vorrichtung zum Messen von Gleichströmen, die in einer Leitung (L) fließen, aufweisend:
• einen Transformator (4) mit einem gesättigten Eisenkern, wobei in der Primärwicklung (41) der zu messende Gleichstrom fließt,
**dadurch gekennzeichnet, dass** sie aufweist
• eine Messanordnung, die aufweist:
o einen Zweig zum Erzeugen eines Referenzstromes, der aus einem sinusförmigen Strom mit einem vorbestimmten Effektivwert bzw. quadratischen Mittelwert und einem einstellbaren Gleichstrom besteht und der in eine Sekundärwicklung (42, 42') des Transformators eingeleitet werden soll,
o einen Zweig zum Detektieren der sinusförmigen Komponente des Referenzstromes der Sekundärwicklung des Transformators,
o eine Verarbeitungseinheit (2, 2'), die dazu ausgelegt ist, die Zweige zu steuern, den Wert der Gleichstromkomponente des Referenzstromes einzustellen, bis der Effektivwert der sinusförmigen Komponente einen Maximalwert erreicht,
o wobei die Verarbeitungseinheit den Wert des zu messenden Gleichstromes berechnet als der Wert der in die Sekundärwicklung des Transformators eingeleiteten Referenz-Gleichstromkomponente multipliziert mit einer Proportionalitätskonstanten, die während des Einstellens des Wertes des Gleichstromes erhalten wurde.

2. Vorrichtung nach Anspruch 1, wobei der Erzeugungs-Zweig einen Digital-/Analog-Konverter (21, 21'), der von der Verarbeitungseinheit gesteuert wird, und wenigstens eine Verstärkereinheit (31, 31') aufweist.

3. Vorrichtung nach Anspruch 1, wobei der Detektions-Zweig einen Analog/Digital-Konverter (22, 22'), der von der Verarbeitungseinheit gesteuert wird, und wenigstens einen Bandpassfilter (32, 32') aufweist.

4. Vorrichtung nach Anspruch 1, die zwei Messanordnungen aufweist, die jeweils mit einer entsprechenden Sekundärwicklung (42, 42') des Transformators verbunden sind.

5. Verfahren zum Messen eines Gleichstroms, der in einer Leitung (L) fließt, **dadurch gekennzeichnet, dass** es die folgenden Schritte aufweist:
a) Einspeisen des zu messenden Gleichstromes in die Primärwicklung eines Transformators, der einen magnetisch gesättigten Eisenkern besitzt,
b) Einleiten eines Referenzstromes, der aus einer einstellbaren Gleichstromkomponente und einer sinusförmigen Komponente mit vorbestimmter Frequenz und Effektivwert besteht, in eine Sekundärwicklung des Transformators in solch einer Weise, dass der magnetisch gesättigte Eisenkern aus der Sättigung gebracht wird,
c) Detektieren der sinusförmigen Stromkomponente und Vergleichen mit dem sinusförmigen Anteil des eingeleiteten Referenzstromes,
d) Einstellen der Gleichstromkomponente des Referenzstromes bis zu einem Wert, an dem der Effektivwert der sinusförmigen Komponente den Maximalwert einnimmt,
e) Berechnen des Wertes des bei Schritt a) zu messenden Gleichstromes als der Wert der in die Sekundärwicklung des Transformators eingeleiteten Referenz-Gleichstromkomponente, der während des Schritts d) des Einstellens erhalten wurde, multipliziert mit einer Proportionalitätskonstanten.

6. Verfahren nach Anspruch 5, weiter aufweisend die Schritte:
f) Wiederholen der in den Schritten a) - e) durchgeführten Messungen unter Verwendung von zwei Vorrichtungen nach Anspruch 1,
g) Vergleich der Ergebnisse der beiden Messungen.

## Revendications

1. Appareil de mesure de courants continus s'écoulant dans une ligne (L), comprenant :
- un transformateur (4) ayant un noyau de fer saturé, dans lequel le courant continu à mesurer s'écoule dans l'enroulement primaire (41),
**caractérisé en ce qu'**il comprend :
- un bloc de mesure comprenant :
- une branche pour générer un courant de référence constitué d'un courant sinusoïdal ayant une valeur moyenne quadratique prédéterminée et d'un courant continu ajustable à envoyer à un enroulement secondaire (42, 42') dudit transformateur,
- une branche pour détecter la composante sinusoïdale dudit courant de référence de l'enroulement secondaire dudit transformateur,
- une unité de traitement (2, 2') apte à commander lesdites branches pour ajuster la valeur de ladite composante de courant continu du courant de référence jusqu'à ce que la valeur moyenne quadratique de la composante sinusoïdale atteigne une valeur maximale,
- ladite unité de traitement calcule la valeur du courant continu à mesurer en tant que valeur de la composante de référence de courant continu envoyée à l'enroulement secondaire dudit transformateur multipliée par une constante de proportionnalité obtenue au cours de l'ajustement de la valeur dudit courant continu.

2. Appareil selon la revendication 1, dans lequel ladite branche de génération comprend un convertisseur numérique-analogique (21, 21') commandé par ladite unité de traitement et au moins un bloc d'amplification (31, 31').

3. Appareil selon la revendication 1, dans lequel ladite branche de détection comprend un convertisseur analogique-numérique (22, 22') commandé par ladite unité de traitement et au moins un filtre passe-bande (32, 32').

4. Appareil selon la revendication 1, comprenant deux blocs de mesure qui sont chacun associés à un enroulement secondaire respectif (42, 42') dudit transformateur.

5. Procédé de mesure d'un courant continu s'écoulant dans une ligne (L), **caractérisé en ce qu'**il comprend les étapes suivantes :
a) l'insertion du courant continu à mesurer dans l'enroulement primaire d'un transformateur ayant un noyau magnétique de fer saturé,
b) l'envoi, dans un enroulement secondaire dudit transformateur, d'un courant de référence constitué d'une composante de courant continu ajustable et d'une composante sinusoïdale avec une fréquence prédéterminée et une valeur moyenne quadratique, de manière à supprimer la saturation dudit noyau magnétique de fer saturé,
c) la détection de ladite composante de courant sinusoïdale et la comparaison de celle-ci à la portion sinusoïdale du courant de référence envoyé,
d) l'ajustement de ladite composante de courant continu du courant de référence jusqu'à une valeur à laquelle la valeur moyenne quadratique de la composante sinusoïdale prend la valeur maximale,
e) le calcul de la valeur du courant continu à mesurer à l'étape a) en tant que valeur de la composante de courant continu de référence envoyée à l'enroulement secondaire dudit transformateur obtenue à l'étape d) d'ajustement multipliée par une constante de proportionnalité.

6. Procédé selon la revendication 5, comprenant en outre les étapes de :
f) la répétition de la mesure effectuée aux étapes a) à e) au moyen de deux appareils selon la revendication 1,
g) la comparaison des résultats des deux mesures.
